# EUROPÄISCHE PATENTSCHRIFT

(11) **EP 3 069 115 B1**
(45) Veröffentlichungstag und Bekanntmachung des Hinweises auf die Patenterteilung: **03.04.2019**
(21) Anmeldenummer: 14803036.4
(22) Anmeldetag: 13.11.2014
(51) Int. Cl.: G01L 1/16, H01L 41/047, H01R 4/48, H01R 13/33, G01L 1/04

(54) **PIEZOELEKTRISCHER KRAFTSENSOR MIT ELEKTRISCHER VERBINDUNG ZWISCHEN ELEKTRODE UND KONTAKTPIN**
PIEZOELECTRIC FORCE SENSOR HAVING AN ELECTRICAL CONNECTION BETWEEN ELECTRODE AND CONTACT PIN
CAPTEUR DE FORCE PIÉZOÉLECTRIQUE MUNI D'UNE CONNEXION ÉLECTRIQUE ENTRE UNE ÉLECTRODE ET UNE BROCHE DE CONTACT

(30) Priorität: 14.11.2013 CH 19092013
(43) Veröffentlichungstag der Anmeldung: 21.09.2016
(73) Patentinhaber: Kistler Holding AG, 8408 Winterthur (CH)
(72) Erfinder: KOHLER, Denis, CH-8413 Neftenbach (CH); SCHNEIDER, Harry, CH-8444 Henggart (CH); DEGEN, Werner, CH-8050 Zürich (CH)
(86) Internationale Anmeldenummer: PCT/CH2014/000163
(87) Internationale Veröffentlichungsnummer: WO 2015/070357

(56) Entgegenhaltungen:
- EP-B1- 2 174 106
- DE-A1- 4 441 303
- GB-A- 945 130
- GB-A- 2 263 202
- US-B1- 7 704 107
- US-B1- 8 408 951

## Beschreibung

### Technisches Gebiet

Die vorliegende Erfindung beschreibt einen piezoelektrischen Kraftsensor umfassend ein Gehäuse mit mindestens einem piezoelektrischen Körper und einer mit diesem Körper elektrisch verbundenen Elektrode, wobei am Gehäuse eine Anschlussvorrichtung mit einem Kontaktpin befestigt oder angeformt ist zum Weiterleiten von Messsignalen, und wobei der Kontaktpin mit der Elektrode elektrisch leitend verbunden ist.

### Stand der Technik

In einigen technischen Gebieten werden Kraftsensoren, insbesondere piezoelektrische Kraftsensoren, umfassend mindestens einen piezoelektrischen Körper, eingesetzt. Derartige piezoelektrische Kraftsensoren sind in unterschiedlichen Ausführungsformen für eine Komponente zur Messung von Kräften in einer Raumrichtung (Fz) bis zu sechs Komponenten, zur Messung von Kräften und Momenten (Fx, Fy, Fz, Mx, My, Mz), kommerziell erhältlich. Die Anwendungsgebiete liegen in Kraftmessungen in der Montagetechnik, beispielsweise beim Punktschweissen und in Pressen, der Messung von Schnitt- und Umformkräften, sowie im Bereich der Bestimmung von Bremskräften in Schienenfahrzeugen.

Bekannte piezoelektrische Kraftsensoren, welche neben der Kraftmessung auch zur Bestimmung des Drehmomentes oder von Beschleunigungskräften einsetzbar sind, sind sogenannte Piezo-Messunterlagsscheiben. Eine solche aus dem Stand der Technik bekannte Piezo-Messunterlagsscheibe 1 zur Messung dynamischer und quasistatischer Kräfte Fz in einer Raumrichtung (z-Richtung) ist in den Figuren 1a und 1b gezeigt und wird im Weiteren näher erklärt. EP 2 174 106 B1 zeigt ebenfalls einen solchen piezoelektrischen Kraftsensor. Die Piezo-Messunterlagsscheibe 1 umfasst ein mehrteiliges Gehäuse 10, an welchem eine Anschlussvorrichtung 13 befestigt oder angeformt ist. Das Gehäuse 10 ist in der Regel aus Stahl hergestellt und weist einen Deckel und einen Boden auf. Im Gehäuse 10 ist eine zentrische Aussparung 100 vorgesehen, durch welche eine nicht dargestellte Vorspannschraube durchführbar ist. Im Gehäuse 10 sind hier zwei piezoelektrische Körper 11, 11' ringförmig ausgestaltet übereinander gestapelt angeordnet. Zwischen den piezoelektrischen Körpern 11, 11', die jeweils als Ringkörper ausgestaltet sind, befindet sich eine Elektrode 12. Die Elektrode 12 weist einen Elektrodenkörper 120 auf, welcher als Ringkörper gestaltet ist und an welchem eine Elektrodenfahne 121 radial wegführend angeformt oder angeschweisst ist. An der Elektrodenfahne 121 ist ein in Richtung z-Achse gebogenes Verbindungsblech 122 angeschweisst.

In der Gehäuseumfangswand ist eine Anschlussöffnung 101 ausgespart, welche in eine Durchführung 130 der Anschlussvorrichtung 13 führt. Die Elektrodenfahne 121 und das Verbindungsblech 122 ragen durch die Anschlussöffnung 101 in den Innenraum der Durchführung 130 bis zu einem Kontaktpin 131 der Anschlussvorrichtung 13. Der Kontaktpin 131 ist mittels Isolation 132 elektrisch isoliert gegen die Wände der Durchführung 130 und das Gehäuse 10 befestigt aufgebaut. Der Kontaktpin 131 ist über das Verbindungsblech 122 mit der Elektrodenfahne 121 elektrisch leitend stoffschlüssig verbunden. Für die äussere Verkabelung der Piezo-Messunterlagscheibe 1 mit einer Messelektronik werden Anschlusskabel in Form von hochisolierenden Koaxialkabeln mit geringer Kapazität verwendet. Diese Anschlusskabel erzeugen bei minimaler Bewegung nur eine minimale Reibungselektrizität. Derartige Anschlusskabel für den industriellen Einsatz sind kommerziell erhältlich und einfach an die Anschlussvorrichtung 13 der Piezo-Messunterlagscheibe 1 anschliessbar, womit Ladungssignale vom Kontaktpin 131 abnehmbar sind. Damit die Piezo-Messunterlagsscheibe 1 Kräfte messen kann, müssen die Komponenten im Gehäuse 10 in z-Richtung aufeinander drückend angeordnet und die Komponenten so unbewegbar im Gehäuse verschweisst sein.

Für den Messbetrieb wird die Piezo-Messunterlagsscheibe 1 mittels Vorspannschraube zwischen zwei planparallelen Flächen einer Maschinenstruktur unter Vorspannung eingebaut. Bei Belastung in z-Richtung gibt die Piezo-Messunterlagsscheibe 1 elektrische Ladungen proportional zur wirkenden Kraft Fz ab. Durch eine auf die piezoelektrischen Körper wirkende Kraft und Ausnutzung des piezoelektrischen Effektes treten Ladungssignale bei Belastung auf, welche über die Elektrode 12 die Durchführung 130 querend an den Kontaktpin 131 geführt werden, wo die Ladungssignale von ausserhalb des piezoelektrischen Kraftsensors 1 abnehmbar und weiterverarbeitbar sind.

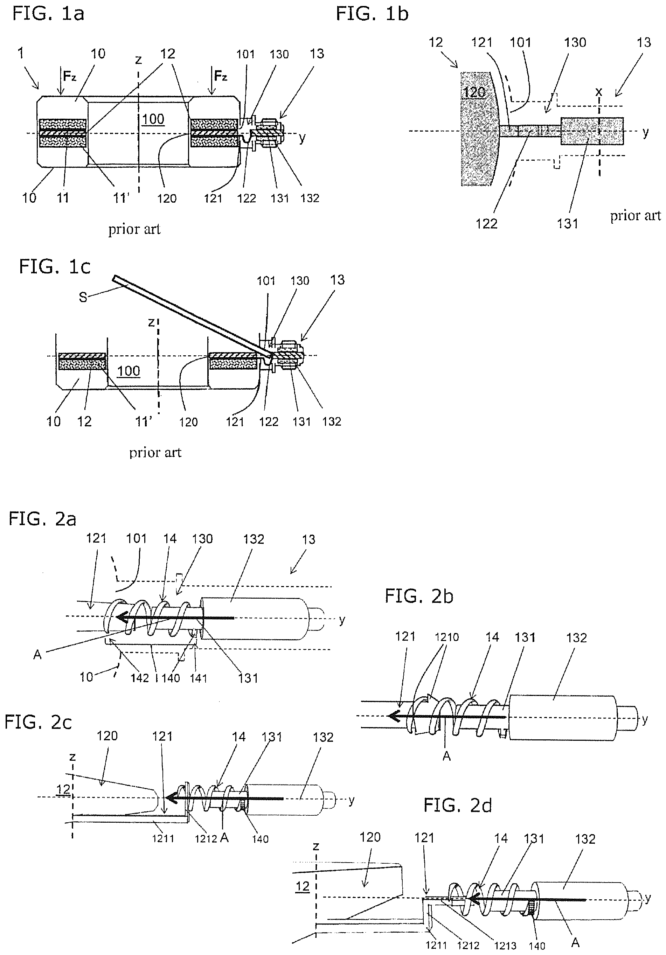

Zur bisherigen Erreichung einer elektrischen Verbindung der Elektrode 12 über die Elektrodenfahne 121 und das Verbindungsblech 122 an dem Kontaktpin 131 wird eine Punktschweissung mittels Widerstands- oder Laserschweissen vorgenommen. Wie in Figur 1c dargestellt wird ein erster piezoelektrischer Körper 11' und die Elektrode 12 im Boden des geöffneten Gehäuses 10 positioniert, wobei die Durchführung 130 bereits an einer Gehäuseumfangsfläche befestigt wurde. Die Elektrodenfahne 121 und das daran befestigte Verbindungsblech 122 werden so platziert, dass sie durch die Durchführung 130 aus dem Gehäuse 10 ragen und das Verbindungsblech 122 vor einer Stirnfläche des Kontaktpins 131 zu liegen kommt. Dann kann eine Schweisselektrode S durch die Anschlussöffnung 101 eingeführt werden, sodass das Verbindungsblech 122 an der Stirnfläche des Kontaktspins 131 angepunktet werden kann, womit die Elektrode 12 unlösbar stoffschlüssig mit dem Kontaktpin 131 verbunden ist.

Da die Piezo-Messunterlagsscheiben 1 mit Durchmessern von einigen Millimetern bis zu einigen Zentimetern hergestellt werden, ist es entsprechend schwierig, die Punktschweissung bei geöffnetem Gehäuse 10 vorzunehmen. Aufgrund der Miniaturbauweise und den verschiedenen Grössenvarianten der erhältlichen Piezo-Messunterlagsscheiben 1 kann die elektrische Verbindung der Elektrode 12 mit dem Kontaktpin 131 der Anschlussvorrichtung 13 heute nicht automatisiert durchgeführt werden.

Beim Widerstandsschweissen treten häufig Verunreinigungen auf, welche störend auf die elektrische Leitfähigkeit der Verbindung zwischen Elektrode 12 und Kontaktpin 131 wirken. Neben einem ungenügenden elektrischen Kontakt zwischen Elektrode 12 und Kontaktpin 131 kann es möglicherweis auch zu Kurzschlüssen beim Anpunkten kommen. Werden derartige schlechte elektrische Verbindungen nicht entdeckt werden, bevor das Gehäuse 10 verschlossen und druckdicht verschweisst wird, dann ist die gesamte Piezo-Messunterlagsscheibe 1 unbrauchbar. In der Regel muss eine genaue Prüfung der Schweissung nach der Durchführung der elektrischen Verbindung und vor dem Verschliessen des Gehäuses 10 manuell stattfinden, was mit Zusatzaufwand verbunden ist.

### Darstellung der Erfindung

Die vorliegende Erfindung hat sich zur Aufgabe gestellt, einen piezoelektrischen Kraftsensor derart zu verbessern, dass eine im Gehäuse des piezoelektrischen Kraftsensors angeordnete elektrische Verbindung zwischen einer Elektrode und einem Kontaktpin reproduzierbar ohne Leitfähigkeitsprobleme erreicht ist, welche zu dem noch einfacher herstellbar ist, als aus dem Stand der Technik bekannt.

Die Aufgabe wird durch die Merkmale des Anspruchs 1 gelöst. Beim erfindungsgemässen Kraftsensor ist als elektrische Verbindung innerhalb des piezoelektrischen Kraftsensors eine Schraubendruckfeder elektrisch leitend mit dem Kontaktpin verbunden. Die Schraubendruckfeder ist lösbar mit der Elektrode derart elektrisch leitend wirkverbunden, dass der Kontaktpin einen Abstand zur Elektrode aufweist. Dabei sind erfindungsgemäss Messsignale von der Elektrode über die Schraubendruckfeder und den angeschlossenen Kontaktpin aus dem Gehäuse des piezoelektrischen Kraftsensors herausleitbar und an der Anschlussvorrichtung abgreifbar.

Der Vorteil dieser Vorrichtung besteht darin, dass mit dieser Verbindung keine Kraft vom Kontaktpin auf die Elektrode übertragen werden kann, selbst wenn stark am Kontaktpin gerüttelt wird. Zudem kann auf eine Schweissung verzichtet werden, da die Verbindung zwischen der Elektrode und der Schraubendruckfeder nun lösbar, also nicht fest ist. Es hat sich herausgestellt, dass diese Verbindung stets sehr zuverlässig einen Kontakt gewährleistet, obwohl sich die Elektrode und die Schraubendruckfeder nur berühren.

Der Begriff "lösbar" bezeichnet im Zusammenhang mit dieser Erfindung lediglich den Umstand, dass die Elektrode und die Schraubendruckfeder nicht unlösbar aneinander angebracht sind, insbesondere nicht aneinander angeschweisst sind, wie dies aus dem Stand der Technik bekannt ist. Da es sich hier um eine Verbindung innerhalb des Kraftsensors handelt, wird diese lösbare Verbindung, wenn sie einmal zustande gekommen ist, niemals wieder gelöst. Die lösbare Verbindung soll demnach nicht mit einer lösbaren Verbindung verwechselt werden, die tatsächlich gelöst wird, wie dies bei Steckverbindungen üblich ist, die nach Belieben verbunden und gelöst werden. Die erfindungsgemässe, an sich lösbare Verbindung innerhalb des Kraftsensors ist unzugänglich und daher technisch unlösbar, ohne den Kraftsensor zu zerstören. Trotzdem ist die Verbindung an sich, wenn sie alleine betrachtet wird, lösbar.

### Kurze Beschreibung der Zeichnungen

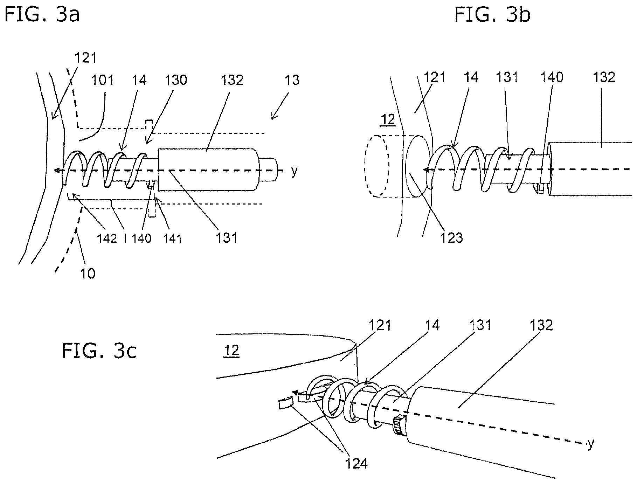

Ein bevorzugtes Ausführungsbeispiel des Erfindungsgegenstandes wird nachstehend im Zusammenhang mit den anliegenden Zeichnungen beschrieben. Gleiche Bezugszeichen beziehen sich jeweils auf dieselben Komponenten. Dir Figuren 2 und 3 zeigen erfindungsgemässe Ausführungsformen.
- Figur 1a: zeigt eine teilweise geschnitten dargestellte Seitenansicht eines piezoelektrischen Kraftsensors in Form einer Piezo-Messunterlagsscheibe gemäss Stand der Technik, während
- Figur 1b: eine detaillierte Schnittansicht durch einen Teil der Elektrode, einen Kontaktpin mit daran angeschweisster Elektrodenfahne, der Piezo-Messunterlagsscheibe aus Figur 1a ohne Darstellung der piezoelektrischen Körper zeigt und
- Figur 1c: die stoffschlüssige Befestigung des Verbindungsbleches bzw. der Elektrodenfahne am Kontaktpin in einer teilweisen Schnittdarstellung, vor dem Verschluss des Gehäuses zeigt.
- Fig. 2a: zeigt eine perspektivische Ansicht einer elektrischen Verbindung, umfassend einen Kontaktpin mit Schraubenfeder, wobei eine keilförmige Elektrodenfahne aufgesteckt ist, während
- Fig. 2b: eine perspektivische Ansicht einer elektrischen Verbindung mit einer Elektrodenfahne mit Widerhaken zeigt,
- Fig. 2c: eine weitere Variante einer lösbaren elektrischen Verbindung zwischen einer Elektrodenfahne und einer Schraubenfeder in einer perspektivischen Ansicht zeigt, wobei die Elektrodenfahne L-förmig ausgestaltet ist und ein kürzerer Schenkel zwischen die Windungen gesteckt ist, während
- Fig. 2d: eine perspektivische Ansicht mit einer stufenförmig gestalteten Elektrodenfahne zeigt, wobei ein, der Schraubendruckfeder zugewandter Schenkel teilweise in die Windungen eingesteckt ist.
- Fig. 3a-3c: zeigen Ausführungen in perspektivischen Ansichten ohne Elektrodenfahne, wobei die Schraubenfeder a) auf der Elektrodenumfangsfläche kontaktiert, b) in ein Sackloch in der Elektrodenumfangsfläche eingesteckt oder c) mit Umfangsflächenzähnen an der Elektrode wirkverbunden ist.

### Beschreibung

Im Folgenden wird eine elektrische Verbindung zur Führung elektrischer Signale eines piezoelektrischen Kraftsensors 1, insbesondere einer Piezo-Messunterlagsscheibe 1 mit Hilfe der Figuren 2 und 3 erklärt. Die einfachsten Piezo-Messunterlagscheiben 1 können Kräfte in einer Raumrichtung (hier Fz) zwischen 0 und mehr als 1000 kN messen. Dabei weisen die piezoelektrischen Kraftsensoren 1 mindestens einen piezoelektrischen Körper 11 auf, welcher mit einer Elektrode 12 in einem Gehäuse druckdicht verschweisst angeordnet ist. Eine elektrische Verbindung sorgt dafür, dass von ausserhalb des Gehäuses 10 elektrische Signale entnehmbar sind. Von ausserhalb des Gehäuses 10 wird ein Anschlusskabel an eine Anschlussvorrichtung 13 angeschlossen, wodurch Messsignale an eine Messelektronik mit einem Ladungsverstärker entnehmbar sind.

Da es hier im speziellen um die elektrische Verbindung innerhalb des piezoelektrischen Kraftsensors 1 geht, wurden der Übersichtlichkeit halber hier der mindestens eine piezoelektrische Körper 11 und das Gehäuse 10, welche wie aus dem Stand der Technik bekannt ausgeführt sein können, nicht dargestellt bzw. nur gestrichelt angedeutet. Die Anschlussvorrichtung 13 des piezoelektrischen Kraftsensors 1 bildet zusammen mit dem des Gehäuses 10 einen gemeinsamen Innenraum um die Anschlussöffnung 101 herum, der dicht verschlossen ist. Die Anschlussvorrichtung 13 ist untrennbar am Gehäuse 10 angebracht, vorzugsweise angeschweisst. Von aussen ist kein Zugang zu diesem Innenraum gegeben, weder durch das Gehäuse noch durch die Anschlussvorrichtung 13, dessen Durchführung 130 dicht ist.

Der innere Aufbau des Kraftsensors 1 kann insbesondere so gebaut sein, wie in den Figuren 1 dargestellt und beschrieben ist, abgesehen von der Verbindung zwischen der Elektrode 12 und dem Kontaktpin. Gezeigt ist in den Figuren 2 und 3 jeweils eine Elektrode 12 mit einem Elektrodenkörper 120, mit oder ohne Elektrodenfahne 120, wobei die Elektrode 12 in einem Gehäuse 10 zu liegen kommt, wie in den Figuren 1 beschrieben. Die elektrische Verbindung wird zwischen der Elektrode 12 bzw. der Elektrodenfahne 120 und einem Kontaktpin 131 in Form einer lösbaren Verbindung ausgestaltet.

Der Kontaktpin 131 ist Teil einer Anschlussvorrichtung 13, welche an das Gehäuse 10 anschiessend angeordnet ist. Der Kontaktpin 131 ist elektrisch leitend ausgeführt und der Kontaktpin 131 ist im vom Gehäuse 10 abgewandten Abschnitt mit einer Isolation 132 umhüllt. Damit ist eine isolierte Führung elektrischer Ladungen von der Elektrode 12 durch den Kontaktpin 131 in die Anschlussvorrichtung 13 erreichbar. An der Anschlussvorrichtung 13 und damit ausserhalb des Gehäuses 10 können einfach geeignete Anschlusskabel mit entsprechenden Steckern oder Buchsen lösbar angeschlossen werden, beispielsweise mittels eines Schraubgewindes. Andererseits kann ein Anschlusskabel auch fest resp. unlösbar an der Anschlussvorrichtung 13 angebracht sein zum Weiterleiten der Messsignale.

Um die elektrische Verbindung zwischen Elektrode 12 und Kontaktpin 131 und damit die Leitung elektrischer Signale, insbesondere der Messsignale, von der Elektrode 12 aus dem Gehäuse 10 heraus zu schaffen, wird eine Schraubendruckfeder 14 aus einem elektrisch leitenden Material eingesetzt, die mit einem kontaktpinseitigen Ende 141 am Kontaktpin 131 befestigt ist, vorzugsweise unlösbar stoffschlüssig, bevorzugt mittels Schweissung. Diese stoffschlüssige Verbindung ist als Federbefestigung 140 am kontaktpinseitigen Ende 141 der Schraubendruckfeder 14 angeordnet. Die Schraubendruckfeder 14 weist eine Federlänge l auf und wird verschiedenartig mit der Elektrode 12 in Kontakt gebracht. Dabei wird jeweils ein elektrodenseitiges Ende 142 der Schraubendruckfeder 14 lösbar mit der Elektrode 12 bzw. mit der Elektrodenfahne 121 verbunden. Die Elektrode 12 und der Kontaktpin 131 weisen einen Abstand zueinander auf, welcher durch die Schraubendruckfeder 14 überbrückt ist. Eine Berührung der Elektrode 12 durch den Kontaktpin 131 ist vermieden.

Durch diese beabstandete und indirekte Verbindung über die Schraubendruckfeder 14 wird der Kontaktpin 131 von der Elektrode mechanisch entkoppelt, da die Schraubendruckfeder 14 an der Elektrode 12 nur anliegt, sodass keine Kraft vom Kontaktpin 131 auf die Elektrode 12 übertragbar ist.

Durch Wahl einer Schraubendruckfeder 14 können Kräfte in allen drei Raumrichtungen x, y, z durch die Schraubendruckfeder 14 gefedert aufgenommen werden. Die Messgenauigkeit des piezoelektrischen Kraftsensors 1 mit einer solchen elektrischen Verbindung ist gesteigert, da kaum noch Störeinflüsse aufgrund der Kabelverbindung von der Anschlussvorrichtung 13 auf die elektrische Verbindung wirken.

Die Herstellung einer solchen elektrischen Verbindung als Teil des Aufbaus des piezoelektrischen Kraftsensors 1 ist unkompliziert und wesentlich schneller und vor allem ohne Verunreinigungen, im Vergleich zum Stand der Technik, möglich. Durch die gesteckte Verbindung zwischen der Schraubendruckfeder 14 und der Elektrode 12 bzw. der Elektrodenfahne 121 werden die Oberflächen des Federdrahtes und der Elektrode 12 bzw. der Elektrodenfahne 121 nicht beeinflusst oder verschmutzt.

In einer Variante gemäss Figur 2a ist die Elektrodenfahne 121 keilförmig ausgestaltet. Die Elektrodenfahne 121 muss mindestens teilweise keilförmig ausgeführt sein. Die Schraubendruckfeder 14 ist in Richtung ihrer Federachse A auf die Elektrodenfahne 121 gesteckt und der keilförmige Teil in den Windungsdurchmesser der Schraubendruckfeder 14 eingesteckt. Hier sind zwei Windungen auf der Elektrodenfahne 121 klemmend dargestellt, es können aber auch mehr als zwei Windungen die leitende Verbindung erzeugen. Wichtig ist, dass die Stirnseite des Kontaktpins 131 einen Abstand von der Elektrodenfahne 121 aufweist, sodass eine Federwirkung ausgenutzt werden kann. Aufgrund der Torsion der Schraubendruckfeder 14 bei eingestecktem keilförmigem Teil schmiegt sich der Federdraht um die Elektrodenfahne 121, wobei eine elektrisch leitende Verbindung entsteht, die aufgrund der Torsionsspannung für den Messbetrieb eines piezoelektrischen Kraftsensors 1 ausreichend stabil ist. Elektrische Signale können von der Elektrode 12 über die Elektrodenfahne 121 und die Schraubendruckfeder 14 bis zum Kontaktpin 131 übertragen werden.

Um ein ungewünschtes Herausrutschen der Schraubendruckfeder 14 aus der Elektrodenfahne 121 weiter zu erschweren, sind in der Variante gemäss Figur 2b zusätzlich Widerhaken 1210 an der Elektrodenfahne 121 vorgesehen. Die Ausgestaltung mit mindestens einem Widerhaken 1210 führt dazu, dass eine ungewünschte Trennung der Verbindung von Elektrodenfahne 121 und Schraubendruckfeder 14 nahezu unterbunden ist. Auch hier umschliessen zwei Windungen den eingesteckten Teil der Elektrodenfahne 121, wodurch eine zur Verwendung in einem piezoelektrischen Kraftsensor 1 ausreichende lösbare elektrische Verbindung entsteht. Auch hier kann der eingesteckte Teil der Elektrodenfahne 121 von mehr als zwei Windungen umgeben sein, allerdings muss jeweils ein ausreichender Abstand der Stirnfläche des Kontaktpins 131 von der Elektrodenfahne 121 gewährleistet sein, um eine Federwirkung zu erreichen.

In der Variante gemäss Figur 2c, weist die Elektrodenfahne 121 eine L-förmige Gestalt auf. Ein erster Schenkel 1211 der Elektrodenfahne 121 ragt von dem Elektrodenkörper 120 weg, bevorzugt radial von der Elektrodenumfangsfläche. Ein zweiter Schenkel 1212 schliesst sich an den ersten Schenkel 1211 um etwa 90° abgewinkelt in z-Richtung an. Der zweite Schenkel 1212 ist hier kürzer ausgeführt als der erste Schenkel 1211 und ist zwischen die Windungen der Schraubendruckfeder 14 eingesteckt. Der zweite Schenkel 1212 berührt den Federdraht zwischen den Windungen der Schraubendruckfeder 14, wodurch eine elektrisch leitende lösbare Verbindung zwischen Elektrode 12 und Kontaktpin 131 mittels Schraubendruckfeder 14 erreicht ist. Auch hier ist die Schraubendruckfeder 14 stoffschlüssig mit dem Kontaktpin 131 an der Federbefestigung 140 verbunden, wodurch die elektrisch leitende Verbindung hergestellt ist. Damit das Einstecken des zweiten Schenkels 1212 zwischen die Windungen möglich ist, ist hier die Federachse A der Schraubendruckfeder 14 in einer Höhe die etwa zentral zur Dicke der Elektrode 12 verläuft, angeordnet. Die Federachse A verläuft hier auf Höhe und entlang der y-Achse. In z-Richtung z ist der erste Schenkel 1211 vom Zentrum der Elektrode 12 in z-Richtung zu einer Seitenfläche der Elektrode 12 versetzt angeordnet. Durch diese L-förmige Ausgestaltung der Elektrodenfahne 121 kann der zweite Schenkel 1212 hier von unten zwischen die Windungen ragend eingesteckt werden.

In Figur 2d ist eine Variante einer elektrischen Verbindung dargestellt, wobei die Elektrodenfahne 121 stufenförmig ausgestaltet ist und der restliche Aufbau dem Aufbau gemäss Figur 2c entspricht. Auch hier mündet ein erster Schenkel 1211 in einen zweiten Schenkel 1212, abgewinkelt in z-Richtung, wonach anschliessend ein Übergang in einen dritten Schenkel 1213 bei Abwinklung in die y-Richtung erfolgt. Der erste Schenkel 1211 und der dritte Schenkel 1213 sind hier etwa parallel verlaufend ausgerichtet. Der dritte Schenkel 1213 ist linear in y-Richtung verlaufend teilweise in Richtung Federachse A in die Schraubendruckfeder 14 eingesteckt. Wahlweise kann der dritte Schenkel 1213 keilförmig oder mit Widerhaken versehen ausgebildet sein. Diese Fläche erstreckt sich allerdings senkrecht zur Zeichnungsebene, wodurch dies in der Fig. 2d nicht erkennbar ist. Um 90° gedreht betrachtet könnte der Schenkel 1213 aus der Fig. 2d beispielsweise dem Ende der Elektronenfahne 121 aus Fig. 2b gleichen.

Diese stufenförmige Gestaltung der Elektrodenfahne 121 ist dann nötig, wenn die Federachse A der Schraubendruckfeder 14 etwa zentral zur Dicke des Elektrodenkörpers 120 verlaufen soll, während die Elektrodenfahne 121 in der Nähe einer Seitenfläche der Elektrode 12 angeordnet ist.

In den Figuren 3a bis 3c sind weitere Varianten zur Herstellung der elektrischen Verbindung zwischen der Elektrode 12 und dem Kontaktpin 131 dargestellt. Dabei ist die jeweils verwendete Schraubendruckfeder 14, welche elektrisch leitend und unlösbar mit dem Kontaktpin 131 verbunden ist, noch nicht im Kontakt mit der Elektrode 12 und entsprechend Elektrode 12 und Kontaktpin 131 noch nicht elektrisch leitend lösbar verbunden.

In einer Variation kann eine Bohrung 123 hier in Form eines Sackloches 123 im Elektrodenkörper 120 angeordnet sein, in welche die Schraubendruckfeder 14 teilweise einsteckbar ist. Dies ist in Figur 3b gezeigt. Das elektrodenseitige Ende 142 der Schraubendruckfeder 14 wird in die Bohrung 123 versenkt, wobei die Länge l der Schraubendruckfeder 14 und insbesondere der federnde Teil der Schraubendruckfeder 14 so gross gewählt ist, dass der Kontaktpin 131 nicht direkt in Kontakt mit der Elektrodenumfangsfläche kommt.

Dies gilt auch für die Variante gemäss Figur 3c, wobei Umfangsflächenzähne 124 an der Elektrodenumfangsfläche angeordnet sind, mit welchen die Schraubendruckfeder 14 wirkverbindbar ist. Hier wird durch Aufstecken einiger Windungen der Schraubendruckfeder 14 bei Bewegung der Federachse in y-Richtung eine lösbare elektrische Verbindung der Schraubendruckfeder 14 mit den angeformten oder befestigten Umfangsflächenzähnen 124 erreicht. Die Umfangsflächenzähne 124 können unterschiedliche Formen aufweisen und unterschiedlich tief zwischen die Windungen der Schraubendruckfeder 14 eingesteckt werden.

Sollte die Anschlussvorrichtung 13 und damit der Kontaktpin 131 von aussen mit Kräften in eine der drei Raumrichtungen beaufschlagt werden, dann federt die Schraubendruckfeder 14 diese Kräfte weitgehend ab, sodass keine oder nur minimale Kräfte auf die Elektrode 12 und eventuell auf den piezoelektrischen Körper 11 wirken.

Bei der Herstellung eines piezoelektrischen Kraftsensors 1 wird die Schraubendruckfeder 14 von ausserhalb des Gehäuses 10 durch die Anschlussöffnung 101 geführt und mit der Elektrode 12 auf verschiedenen Arten wirkverbunden, wobei eine lösbare elektrisch leitende Verbindung hergestellt wird. Die Schraubendruckfeder 14 wird dabei vorgespannt mit der Elektrode 12 verbunden. Der Kontaktpin 131 bleibt bei der Herstellung der elektrischen Verbindung zwischen Elektrode 12 und Schraubendruckfeder 14 von der Elektrode 12 beabstandet. Damit kann die federnde Wirkung der Schraubendruckfeder 14 ausgenutzt werden.

Der Kontaktpin 131 und die Isolation 132 können in der Durchführung 130 fest angeordnet sein und nach Herstellung der Verbindung zwischen Schraubendruckfeder 14 und der Elektrode 12 kann die Durchführung 130 der Anschlussvorrichtung 13 am Gehäuse 10 fixiert, insbesondere verschweisst werden.

Es ist aber auch möglich, dass die Durchführung 130 der Anschlussvorrichtung 13 bereits fest mit dem Gehäuse 10 verbunden ist, bevor die Schraubendruckfeder 14, der Kontaktpin 131 und die Isolation 132 die Durchführung 130 teilweise querend befestigt werden.

Bei allen Varianten ist von der Gesamtzahl an Windungen der Schraubendruckfeder 14 mindestens eine Windung am kontaktpinseitigen Ende 141 der Schraubendruckfeder 14 über den Kontaktpin 131 geschoben, während einige Windungen im Bereich des elektrodenseitigen Endes 142 frei und vom Kontaktpin 131 beabstandet sind. Die frei vom Kontaktpin 131 befindlichen Windungen können Kräfte abfedern.

Als Material für die Schraubendruckfeder 14 kommen nur elektrisch leitfähige Materialien in Frage. Neben bevorzugten bekannten Federstählen, welche nichtrostend sein sollten, können Nickel- oder Kupfer-Legierungen eingesetzt werden.

Die Schraubendruckfeder 14 kann mit konstantem Windungsdurchmesser ausgeführt sein und eine zylindrische Grundform bilden. Die Schraubendruckfeder 14 kann aber auch als Kegelfeder oder kegelstumpfförmige Schraubendruckfeder mit abnehmendem Windungsdurchmesser oder mit verschiedenen Bereichen mit unterschiedlichen Windungsdurchmessern gestaltet sein. Die Steigung der Windungen aus Federdraht kann verschieden gewählt sein und kann ebenfalls im Verlauf der Länge l der Schraubendruckfeder 14 variieren.

Die hier am Beispiel eines einfachen piezoelektrischen Kraftsensors zur Messung von Kräften in einer Raumrichtung beispielhaft beschriebene elektrische Verbindung, kann auch für piezoelektrische Kraftsensoren mit mehr als einem piezoelektrischen Körper verwendet werden. Derartige piezoelektrische Kraftsensoren 1 erlauben die Messung von Kräften in zwei Raumrichtungen und mehr mit einem piezoelektrischen Kraftsensor, wobei auch mehr als eine Elektrode verwendet werden kann. Jede Elektrode 12 kann dann mittels hier erläuterter elektrischer Verbindung mit einem Kontaktpin 131 lösbar verbunden werden.

Eine weitere erfindungsgemässe Ausführung umfasst zwei oder mehr Elektroden 12, die jeweils separat auf identische Weise über Schraubendruckfedern 14 zu Kontaktpins 131 kontaktiert sind, sodass zwei oder mehr Messsignale aus der Anschlussvorrichtung 13 des Kraftsensors 1 herausleitbar sind

### Bezugszeichenliste

- 1: piezoelektrischer Kraftsensor / Piezo-Messunterlagsscheibe
- 10: Gehäuse
- 100: zentrische Aussparung
- 101: Anschlussöffnung
- 11: piezoelektrischer Körper (mindestens einer)
- 12: Elektrode (mindestens eine)
- 120: Elektrodenkörper
- 121: Elektrodenfahne
- 1210: Widerhaken
- 1211: erster Schenkel
- 1212: zweiter Schenkel
- 1213: dritter Schenkel
- 122: Verbindungsblech
- 123: Bohrung / Sackloch
- 124: Umfangsflächenzähne
- 13: Anschlussvorrichtung / z. B. Steck- oder Schraubbuchse
- 130: Durchführung
- 131: Kontaktpin
- 132: Isolation
- 14: Schraubendruckfeder
- 140: Federbefestigung
- 141: kontaktpinseitiges Ende
- 142: elektrodenseitiges Ende
- l: Länge der Schraubendruckfeder
- A: Federachse
- S: Schweisselektrode

## Patentansprüche

1. Piezoelektrischer Kraftsensor (1), umfassend ein Gehäuse (10) mit mindestens einem piezoelektrischen Körper (11) und einer mit diesem Körper (11) elektrisch verbundenen Elektrode (12), wobei am Gehäuse (10) eine Anschlussvorrichtung (13) mit einem Kontaktpin (131) befestigt oder angeformt ist zum Weiterleiten von Messsignalen, wobei der Kontaktpin (131) mit der Elektrode (12) elektrisch leitend verbunden ist, **dadurch gekennzeichnet, dass** als elektrische Verbindung innerhalb des piezoelektrischen Kraftsensors (1) eine Schraubendruckfeder (14) elektrisch leitend mit dem Kontaktpin (131) verbunden ist, dass mindestens eine Windung an einem kontaktpunktseitigen Ende (141) der Schraubendruckfeder (4) über den Kontaktpin (131) geschoben ist, dass das kontaktpunktseitige Ende (141) der Schraubendruckfeder (14) stoffschlüssig mittels Federbefestigung (140) unlösbar am Kontaktpin (131) befestigt ist und ein elektrodenseitiges Ende (142) der Schraubendruckfeder (14) lösbar mit der Elektrode (12) derart elektrisch leitend wirkverbunden ist, dass die Schraubendruckfeder (14) mechanisch entkoppelt an der Elektrode (12) anliegt und der Kontaktpin (131) einen Abstand zur Elektrode (12) aufweist, und Messsignale von der Elektrode (12) über die Schraubendruckfeder (14) und den angeschlossenen Kontaktpin (131) aus dem Gehäuse (10) des piezoelektrischen Kraftsensors (1) herausleitbar und an der Anschlussvorrichtung (13) abgreifbar sind.

2. Piezoelektrischer Kraftsensor (1) gemäss Anspruch 1, wobei die Elektrode (12) eine elektrisch leitfähige Elektrodenfahne (121) aufweist, welche zwischen die Windungen der Schraubendruckfeder (14) eingesteckt lösbar befestigt ist.

3. Piezoelektrischer Kraftsensor (1) gemäss Anspruch 2, wobei die Elektrodenfahne (121) mindestens teilweise keilförmig ausgestaltet ist.

4. Piezoelektrischer Kraftsensor (1) gemäss Anspruch 2 oder 3, wobei die Elektrodenfahne (121) mindestens einen Widerhaken (1210) aufweist.

5. Piezoelektrischer Kraftsensor (1) gemäss einem der Ansprüche 2 bis 4, wobei die Elektrodenfahne (121) eine L-förmige Gestalt mit einem ersten Schenkel (1211) und einem zweiten Schenkel (1212) aufweist, wobei der erste Schenkel (1211) und der zweite Schenkel (1212) in z-Richtung abgewinkelt zueinander angeordnet sind und der zweite Schenkel (1212) zwischen die Windungen der Schraubendruckfeder (14) ragend eingesteckt ist.

6. Piezoelektrischer Kraftsensor (1) gemäss Anspruch 5, wobei der Winkel zwischen erstem Schenkel (1211) und zweitem Schenkel (1212) 90° beträgt.

7. Piezoelektrischer Kraftsensor (1) gemäss einem der Ansprüche 2 bis 4, wobei die Elektrodenfahne (121) eine stufenförmige Gestalt mit einem ersten Schenkel (1211), einem zweiten Schenkel (1212) und einem dritten Schenkel (1213) aufweist, wobei erster Schenkel (1211) und dritter Schenkel (1213) parallel verlaufend ausgerichtet sind.

8. Piezoelektrischer Kraftsensor (1) gemäss Anspruch 1, wobei die Elektrode (12) eine Bohrung (123) eine Elektrodenumfangsfläche querend aufweist, in welche die Schraubendruckfeder (14) eingesteckt ist.

9. Piezoelektrischer Kraftsensor (1) gemäss Anspruch 1, wobei die Elektrode (12) Umfangsflächenzähne (124) auf einer Elektrodenumfangsfläche aufweist, mit welchen die Schraubendruckfeder (14) wirkverbunden ist.

10. Piezoelektrischer Kraftsensor (1) gemäss einem der vorhergehenden Ansprüche, wobei die Schraubendruckfeder (14) stoffschlüssig mittels Federbefestigung (140) unlösbar am Kontaktpin (131) befestigt ist.

11. Piezoelektrischer Kraftsensor (1) gemäss einem der vorhergehenden Ansprüche, umfassend zwei oder mehr Elektroden (12), die jeweils separat auf identische Weise über Schraubendruckfedern (14) zu Kontaktpins (13) kontaktiert sind, sodass zwei oder mehr Messsignale aus der Anschlussvorrichtung (13) herausleitbar sind.

12. Piezoelektrischer Kraftsensor (1) gemäss einem der vorhergehenden Ansprüche, wobei die Anschlussvorrichtung (13) dafür vorgesehen ist, ein Anschlusskabel derart lösbar anzubringen, beispielsweise mittels eines Gewindes, zum Weiterleiten der Messsignale.

13. Piezoelektrischer Kraftsensor (1) gemäss einem der Ansprüche 1 bis 12, wobei an der Anschlussvorrichtung (13) ein Anschlusskabel unlösbar angebracht ist zum Weiterleiten der Messsignale.

## Claims

1. A piezoelectric force sensor (1) comprising a housing (10) including at least one piezoelectric body (11) and an electrode (12) electrically connected to this body (11), wherein a connecting device (13) having a contact pin (131) is secured at the housing (10) or integrally formed therewith for transmitting measurement signals, said contact pin (131) being connected to the electrode (12) in an electrically conductive manner, **characterized in that** a helical compression spring (14) is connected to the contact pin (131) in an electrically conductive manner to form an electrical connection within the piezoelectric force sensor (1), at least one turn at an end (141) of the helical compression spring (14) close to the contact point is placed over said contact pin (131), the end (141) of the helical compression spring (14) close to the contact point is non-releasably attached to the contact pin (131) via spring attachment by means of material bonding, and an end (142) of the helical compression spring (14) close to the electrode (12) is operatively connected to the electrode (12) in a releasable and electrically conductive manner so that the helical compression spring (14) abuts at the electrode (12) and is mechanically decoupled therefrom and the contact pin (131) is spaced apart from the electrode (12), and measurement signals are transmitted from the housing (10) of the piezoelectric force sensor (1) from the electrode (12) via the helical compression spring (14) and the contact pin (131) connected thereto and tapped off at the connecting device (13).

2. The piezoelectric force sensor (1) according to claim 1, wherein the electrode (12) comprises an electrically conductive electrode tab (121) releasably secured by being inserted between the turns of the helical compression spring (14).

3. The piezoelectric force sensor (1) according to claim 2, wherein the electrode tab (121) is at least partially wedge-shaped.

4. The piezoelectric force sensor (1) according to claim 2 or 3, wherein the electrode tab (121) comprises at least one barb (1210).

5. The piezoelectric force sensor (1) according to any of claims 2 to 4, wherein the electrode tab (121) is L-shaped having a first leg (1211) and a second leg (1212), wherein said first leg (1211) and said second leg (1212) are arranged with an angle between them in the z direction and the second leg (1212) is inserted between the turns of the helical compression spring (14) to project between the turns.

6. The piezoelectric force sensor (1) according to claim 5, wherein the angle between the first leg (1211) and the second leg (1212) is 90°.

7. The piezoelectric force sensor (1) according to any of claims 2 to 4, wherein the electrode tab (121) has a stepped shape comprising a first leg (1211), a second leg (1212) and a third leg (1213), said first leg (1211) and third leg (1213) being oriented to extend parallel to one another.

8. The piezoelectric force sensor (1) according to claim 1, wherein the electrode (12) has a bore (123) extending through an electrode circumferential surface, in which bore is inserted the helical compression spring (14).

9. The piezoelectric force sensor (1) according to claim 1, wherein the electrode (12) comprises circumferential surface teeth (124) on an electrode circumferential surface thereof to which teeth the helical compression spring (14) is operatively connected.

10. The piezoelectric force sensor (1) according to any of the preceding claims, wherein the helical compression spring (14) is non-releasably secured at the contact pin (131) via spring attachment (140) by means of material bonding.

11. The piezoelectric force sensor (1) according to any of the preceding claims comprising two or more electrodes (12) each separately contacting contact pins (13) in an identical manner via helical compression springs (14) so that two or more measurement signals can be transmitted from the connection device (13).

12. The piezoelectric force sensor (1) according to any of the preceding claims, wherein the connection device (13) is configured for releasably connecting a connection cable, for example by means of a thread, for transmitting the measurement signals.

13. The piezoelectric force sensor (1) according to any of claims 1 to 12, wherein a connection cable is non-releasably secured at the connecting device (13) for transmitting the measurement signals.

## Revendications

1. Capteur de force piézoélectrique (1) comprenant un boîtier (10) contenant au moins un corps piézoélectrique (11) et une électrode (12) connectée électriquement au corps (11), dans lequel un dispositif de connexion (13) comportant une broche de contact (131) est fixé au boîtier (10) ou formé intégralement avec celui-ci pour transmettre des signaux de mesure, ladite broche de contact (131) étant connectée à l'électrode (12) de manière électriquement conductrice, **caractérisé en ce qu'**un ressort de compression hélicoïdal (14) est relié d'une manière électriquement conductrice à la broche de contact (131) pour former une connexion électrique dans le capteur de force piézoélectrique (1), au moins un tour à une extrémité (141) du ressort hélicoïdal de compression (14) à proximité du point de contact est placé sur ladite broche de contact (131), l'extrémité (141) du ressort hélicoïdal de compression (14) à proximité du point de contact est fixée à la broche de contact (131) de manière non amovible via une fixation par ressort au moyen d'une liaison de matière, et une extrémité (142) du ressort hélicoïdal de compression (14) à proximité de l'électrode (12) est reliée à l'électrode (12) de manière opérationnelle et détachable et électriquement conductrice de sorte que le ressort hélicoïdal de compression (14) vienne en butée sur l'électrode (12) et en soit découplé mécaniquement, la broche de contact (131) est espacée de l'électrode (12), et des signaux de mesure sont transmis du boîtier (10) du capteur de force piézoélectrique (1) à partir de l'électrode (12) via le ressort hélicoïdal de compression (14) et la broche de contact (131) qui y est raccordée et branchés sur le dispositif de connexion (13).

2. Capteur de force piézoélectrique (1) selon la revendication 1, dans lequel l'électrode (12) comprend une languette d'électrode électriquement conductrice (121) fixée de manière amovible en étant insérée entre les tours du ressort de compression hélicoïdal (14).

3. Capteur de force piézoélectrique (1) selon la revendication 2, dans lequel la languette d'électrode (121) est au moins partiellement en forme de cale.

4. Capteur de force piézoélectrique (1) selon la revendication 2 ou 3, dans lequel la languette d'électrode (121) comprend au moins un ardillon (1210).

5. Capteur de force piézoélectrique (1) selon l'une quelconque des revendications 2 à 4, dans lequel la languette d'électrode (121) est en forme de L comportant une première jambe (1211) et une deuxième jambe (1212), dans lequel ladite première jambe (1211) et ladite seconde jambe (1212) sont agencées formant un angle entre elles dans la direction z et la seconde jambe (1212) est insérée entre les tours du ressort hélicoïdal de compression (14) de manière à s'étendre entre lesdits tours.

6. Capteur de force piézoélectrique (1) selon la revendication 5, dans lequel l'angle entre la première jambe (1211) et la deuxième jambe (1212) est de 90°.

7. Capteur de force piézoélectrique (1) selon l'une quelconque des revendications 2 à 4, dans lequel la languette d'électrode (121) a une forme étagée comprenant une première jambe (1211), une deuxième jambe (1212) et une troisième jambe (1213), ladite première jambe (1211) et ladite troisième jambe (1213) étant orientées de manière à s'étendre parallèlement l'une à l'autre.

8. Capteur de force piézoélectrique (1) selon la revendication 1, dans lequel l'électrode (12) comporte un alésage (123) s'étendant à travers une surface circonférentielle d'électrode, dans laquelle est inséré le ressort hélicoïdal de compression (14).

9. Capteur de force piézoélectrique (1) selon la revendication 1, dans lequel l'électrode (12) comprend sur une surface circonférentielle d'électrode des dents de surface circonférentielle (124) auxquelles le ressort hélicoïdal de compression (14) est relié de manière opérationnelle.

10. Capteur de force piézoélectrique (1) selon l'une quelconque des revendications précédentes, dans lequel le ressort de compression hélicoïdal (14) est fixé de manière non amovible sur la broche de contact (131) via une fixation de ressort (140) au moyen d'une liaison de matière.

11. Capteur de force piézoélectrique (1) selon l'une quelconque des revendications précédentes, comprenant deux ou plusieurs électrodes (12) chacune contactant séparément des broches de contact (13) de manière identique par l'intermédiaire de ressorts hélicoïdaux de compression (14), de sorte que deux ou plusieurs signaux de mesure peuvent être transmis depuis le dispositif de connexion (13).

12. Capteur de force piézoélectrique (1) selon l'une quelconque des revendications précédentes, dans lequel le dispositif de connexion (13) est configuré pour connecter de manière amovible un câble de connexion, par exemple au moyen d'un filetage, pour transmettre les signaux de mesure.

13. Capteur de force piézoélectrique (1) selon l'une quelconque des revendications 1 à 12, dans lequel un câble de connexion est fixé de manière non amovible sur le dispositif de connexion (13) pour transmettre les signaux de mesure.
